Europäisches Patentamt

European Patent Office

Office européen des brevets

(19)

(11) Publication number: **0 166 642**
A2

(12) # EUROPEAN PATENT APPLICATION

(21) Application number: **85401064.2**

(22) Date of filing: **30.05.85**

(51) Int. Cl.⁴: **G 11 C 7/00**, G 11 C 8/00, G 11 C 11/24, G 11 C 11/40

(30) Priority: **30.05.84 JP 110288/84**
**15.08.84 JP 169262/84**

(43) Date of publication of application: **02.01.86**
**Bulletin 86/1**

(84) Designated Contracting States: **DE FR GB**

(71) Applicant: **FUJITSU LIMITED, 1015, Kamikodanaka Nakahara-ku, Kawasaki-shi Kanagawa 211 (JP)**

(72) Inventor: **Takamae, Yoshihiro, 8-13-24-303, Akasaka, Minato-ku Tokyo 107 (JP)**
Inventor: **Taguchi, Masao, 4-3-4-201, Araisono, Sagamihara-shi Kanagawa 228 (JP)**

(74) Representative: **Descourtieux, Philippe et al, CABINET BEAU de LOMENIE 55 rue d'Amsterdam, F-75008 Paris (FR)**

(54) **Block-divided semiconductor memory device having divided bit lines.**

(57)     In a semiconductor memory device, memory cells are divided into a plurality of blocks. A plurality of partial bit lines ($BL_1$, $\overline{BL}_1$, $BL_2$, $\overline{BL}_2$, ...) are provided separately for each of the blocks, and a plurality of bus bit lines ($BL_0$, $\overline{BL}_0$) are provided commonly for the respective partial bit lines of each of the blocks. Linked between the partial bit lines ($BL_1$, $\overline{BL}_1$, $BL_2$, $\overline{BL}_2$, ...) and the bus bit lines ($BL_0$, $\overline{BL}_0$) are transfer gates ($Q_1$, $Q'_1$, $Q_2$, $Q'_2$, ...). Data of each memory cell is transferred from the respective partial bit lines via the turned ON transfer gates to the respective bus bit lines ($BL_0$, $\overline{BL}_0$).

ACTORUM AG

## BLOCK-DIVIDED SEMICONDUCTOR MEMORY DEVICE HAVING DIVIDED BIT LINES

### BACKGROUND OF THE INVENTION

#### Field of the Invention

The present invention relates to a semiconductor memory device having memory cells divided into a plurality of separated blocks.

#### Description of the Related Art

In recent years, dynamic metal-oxide semiconductor (MOS) random access memory (RAM) devices have been enlarged to 16 kbits, 64 kbits, and 256 kbits. Thus as the integration density becomes higher, the number of memory cells connected to one bit line becomes larger, increasing the length of bit lines, and increasing the capacitance per one bit line. Simultaneously, the storage capacitance per one memory cell is reduced. As a result, the ratio of the capacitance of a bit line to the storage capacitance of a memory cell, i.e., a so-called C-ratio for determining the accuracy of read data, is deteriorated. To avoid this, in the prior art, it has been suggested to increase the storage capacity of a memory cell by improving the memory cell configuration, i.e., by reducing the thickness of the insulating layers within the memory cell, and in addition, to divide a memory cell array into a plurality of blocks, shortening the bit line length, thus reducing the capacitance thereof. For example, when a (n x n) matrix configuration is divided into a two-division configuration such as n x (n/2) x 2, or four-division configuration such as n x (n/4) x 4, the number of memory cells connected to one bit line is reduced and the capacitance of one bit line is also reduced.

In a prior art block-divided RAM, a series of column decoders are required for each block, thus increasing the area occupied by column decoders, which is disadvantageous to integration. In addition, data buses are also required for each block, and accordingly, the circuits for writing data and reading data via the data buses are complex.

In order to improve this, it is already known to construct only one series of column decoders in a block-divided RAM (see: Fig. 7 of United States Patent No. 4,122,546). In such a RAM, however, since bit lines of each block are forcibly connected to each other, and the resistance of transfer gates for connecting the bit lines to each other is large, the read/rewrite operation speed is deteriorated. In addition, it is impossible to apply such a RAM to a RAM having open bit lines.

SUMMARY OF THE INVENTION

It is an object of the present invention to provide a block-divided RAM having a high read/rewrite operation speed which can be also applied to a RAM having open bit lines.

According to the present invention, a plurality of partial bit lines are provided separately for each of the blocks, and a plurality of bus bit lines are provided commonly for the respective partial bit lines of each of the blocks transfer gates are linked between the partial bit lines and the bus bit lines. The data of each memory cell is transferred from the respective partial bit lines via the turned ON transfer gates to the respective bus bit lines.

Since the bus bit lines are provided in parallel to the partial bit lines, the data of each cell array block is transmitted by only one step via the transfer gates linked between the partial bit line and the bus bit lines, and accordingly, there is no possibility of the operation delays by the transfer gates being serially stored. For addition, since a small number of transfer gates are connected to the bus bit lines, and accordingly, the capacitance thereof is remarkably smaller than that of a bit line to which a large number of cells are connected, this is helpful in high speed operation. In addition, since only one clock signal for driving the transfer gates has to be pulled up, the configuration of a bootstrap circuit is simple. Further, since only one partial bit line pair has to be charged up or discharged, the current therefor is small.

BRIEF DESCRIPTION OF THE DRAWINGS

The present invention will be more clearly understood from the description as set forth below with reference to the drawings, wherein:

Fig. 1 is a circuit diagram of a prior art dynamic RAM having folded bit lines;

Fig. 2 is a circuit diagram of another prior art dynamic RAM having open bit lines;

Fig. 3 is a circuit diagram of still another prior art dynamic RAM having folded bit lines;

Fig. 4 is a circuit diagram of the selection circuit of Fig. 3;

Fig. 5 is a timing diagram showing the operation of the circuit of Fig. 3;

Fig. 6 is a circuit diagram of a further prior art dynamic RAM having folded bit lines;

Fig. 7 is a circuit diagram of the selection circuit of Fig. 6;

Fig. 8 is a timing diagram showing the operation of the circuit of Fig. 6;

Fig. 9 is a circuit diagram of a first embodiment of the dynamic RAM having folded bit lines according to the present invention;

Fig. 10 is a circuit diagram of the sense amplifier of Fig. 9;

Fig. 11 is a circuit diagram of a second embodiment of the dynamic RAM having folded bit lines according to the present invention;

Fig. 12 is a circuit diagram of the sense amplifier of Fig. 11;

Figs. 13 and 14 are timing diagrams showing the operation of the circuit of Fig. 11;

Fig. 15 is a circuit diagram of a third embodiment of the RAM having folded bit lines according to the present invention;

Fig. 16 is a circuit diagram of a fourth embodiment of the RAM having open bit lines according to the present invention;

Fig. 17 is a circuit diagram of a fifth embodiment of the RAM having open bit lines according to the present invention;

Figs. 18 and 20 are circuit diagrams of modifications of the circuit of Fig. 11; and

Fig. 19 is a circuit diagram of a modification of the circuit of Fig. 16.

DESCRIPTION OF THE PREFEPRED EMBODIMENTS

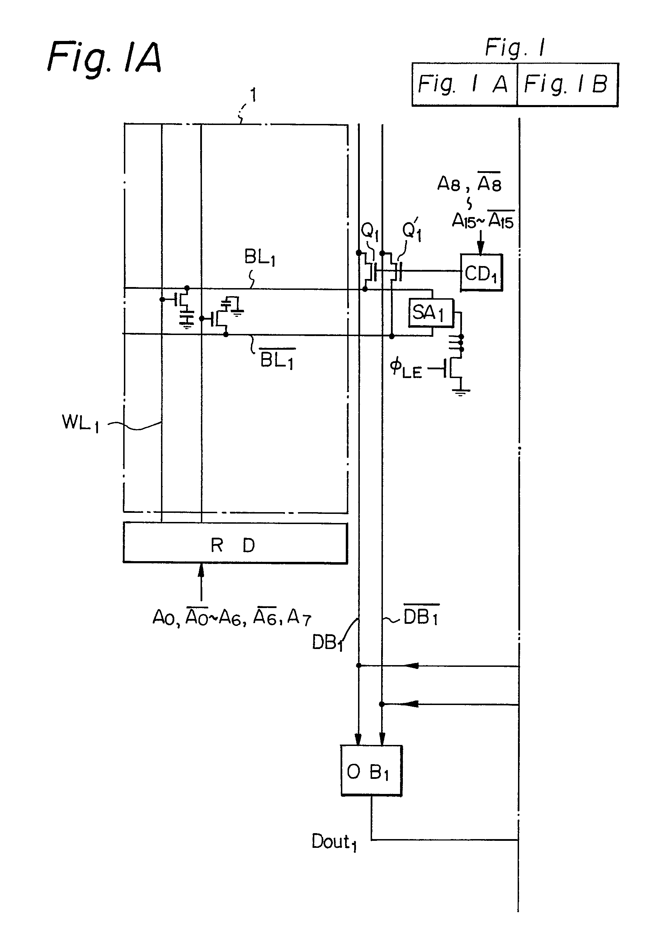

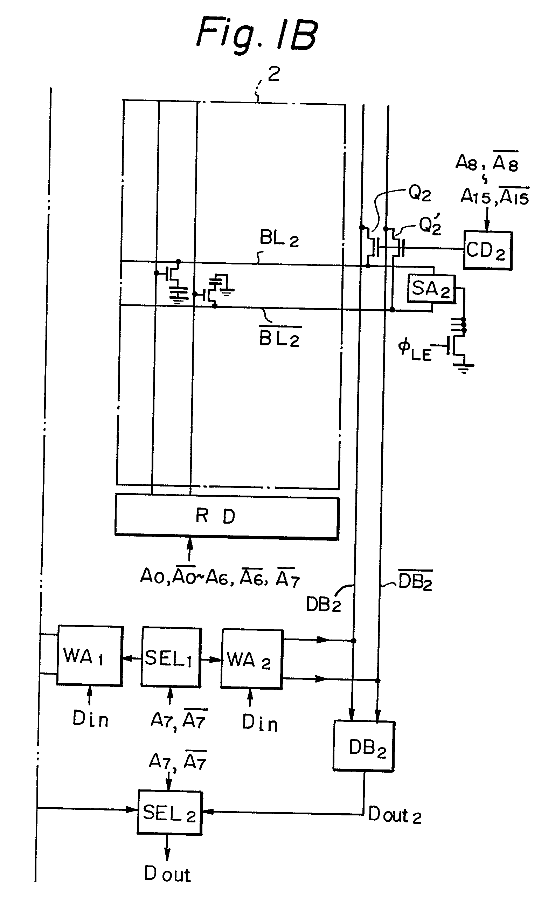

In Fig. 1, which illustrates a prior art RAM having folded bit lines, 64 kbit memory cells are divided into two blocks, i.e., memory cell arrays (128 x 256 bits) 1 and 2. Arranged on the side of the memory cell array are a series of sense amplifiers $SA_1$ and a series of column decoders $CD_1$. Also arranged on the side of the memory cell array 2 are a series of sense amplifiers $SA_2$ and a series of column decoders $CD_2$. Reference RD designates a row decoder. Thus, the illustrated configuration has almost half the bit line length as compared with a one-block configuration RAM having a series of sense amplifiers and a series of column decoders, and accordingly, the C-ratio is halved.

However, column decoders are necessary for each of the blocks, that is, two series of column decoders are necessary, requiring twice the area to be occupied by the column decoders as compared with the one-block configuration, which is disadvantageous to integration.

In addition, since data buses $DB_1$ and $\overline{DB}_1$ , and $DB_2$ and $\overline{DB}_2$ are provided for the blocks, one of the write amplifiers $WA_1$ and $WA_2$ is selected by a selection circuit $SEL_1$ during a write mode for data $D_{in}$ , and one

of the output data $D_{out1}$ and $D_{out2}$ of the output buffers $OB_1$ and $OB_2$ is selected as data $D_{out}$ by a selection circuit $SEL_2$ during a read mode.

Thus, data buses are provided for each of the blocks and the circuits for writing data and reading data become complex.

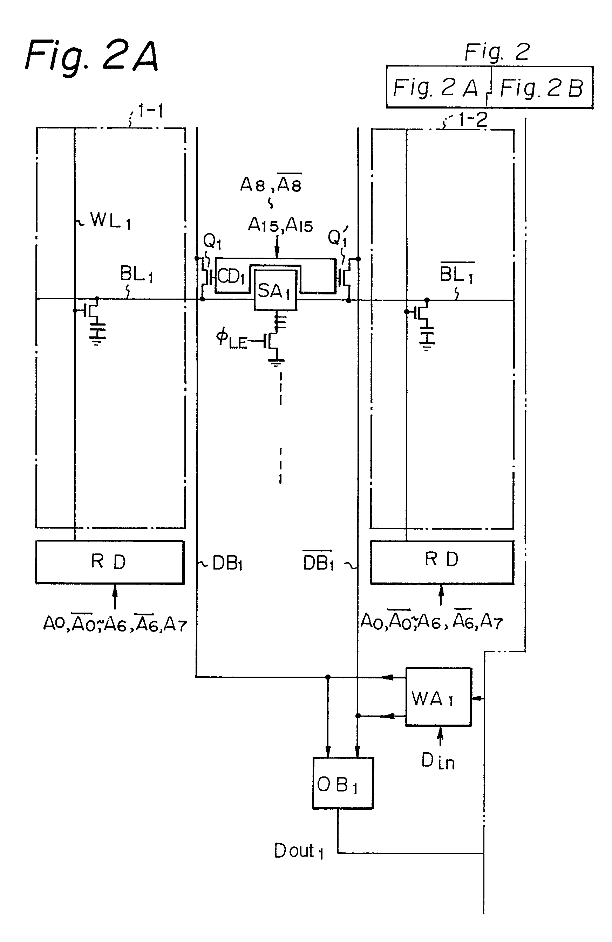

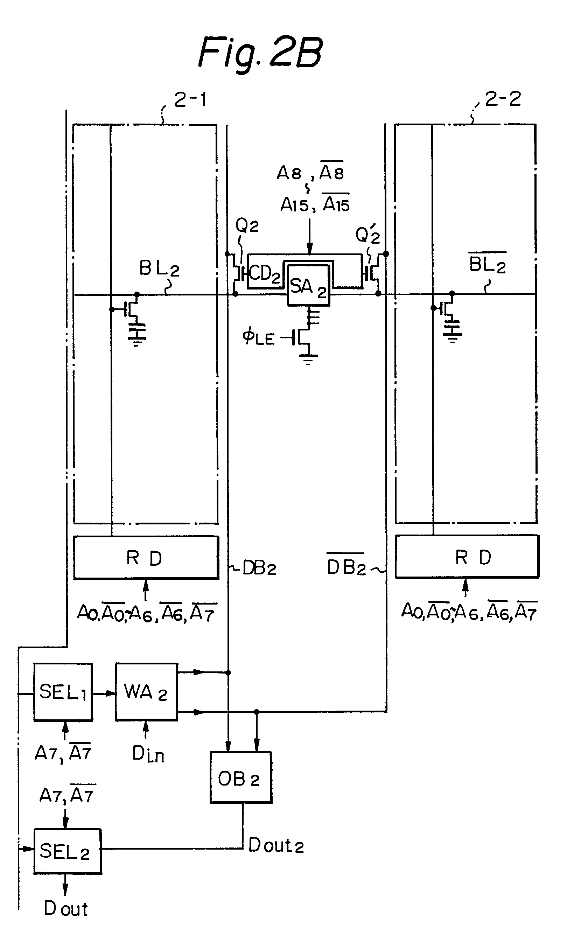

In Fig. 2, note that references $A_0$, $\bar{A}_0$, ..., $A_7$, $\bar{A}_7$ designate row address signals generated by the row address buffers (not shown), and reference $A_8$, $\bar{A}_8$, ..., $A_{15}$, $\bar{A}_{15}$ designate column address signals generated by the column address buffers (not shown). Among these, the signals $A_7$ and $\bar{A}_7$ are used for selecting one of the blocks. References $Q_1$ and $Q_1'$ are transfer gate transistors linked between the bit lines $BL_1$ and $\overline{BL}_1$ and the data buses $DB_1$ and $\overline{DB}_1$, and references $Q_2$ and $Q_2'$ are transfer gate transistors linked between the bit lines $BL_2$ and $\overline{BL}_2$ and the data buses $DB_2$ and $\overline{DB}_2$. Reference $\phi_{LE}$ designates a latch enable signal for enabling the sense amplifiers $SA_1$ AND $SA_2$.

In Fig. 2, which illustrates a prior art RAM having open bit lines, 64 kbit memory cells are also divided into two blocks. That is, memory cell arrays (64 x 256 bits) 1-1 and 1-2 belong to the first block, while memory cell arrays (64 x 256 bits) 2-1 and 2-2 belong to the second block. Arranged between the memory cell arrays 1-1 and 1-2 are a series of sense amplifiers $SA_1$ and a series of column decoders $CD_1$. Also arranged between the memory cell arrays 2-1 and 2-2 are a series of sense amplifiers $SA_2$ and a series of column decoders $CD_2$. Regarding the remaining configuration, the RAM of Fig. 2 is the same as that of Fig. 1. Therefore, in the RAM of Fig. 2, column decoders are also necessary for each of the blocks, that is, two series of column decoders are necessary, requiring twice the area to be occupied by the column decoders as compared with the one-block configuration. In addition, data buses are provided for each of the blocks, and the circuits for writing data and reading data also become complex.

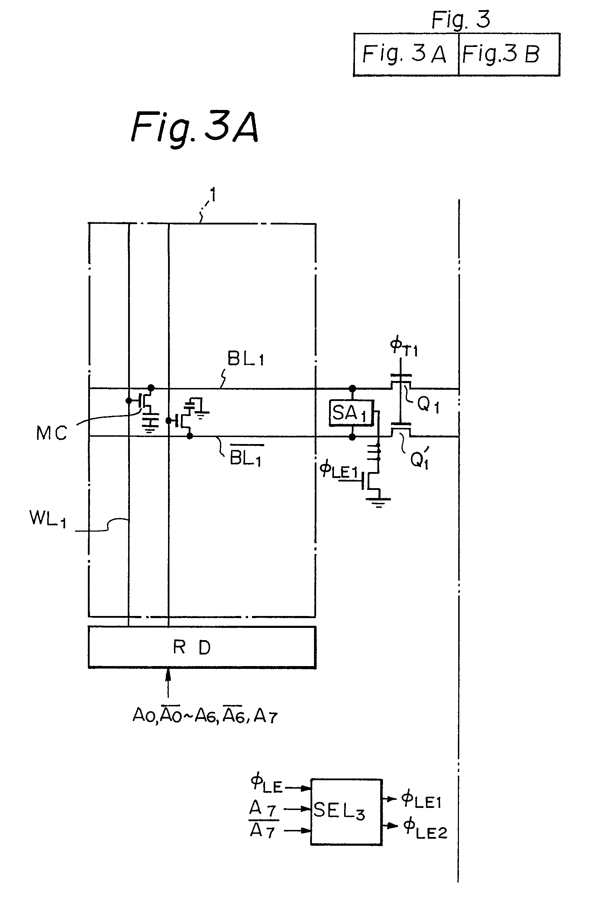

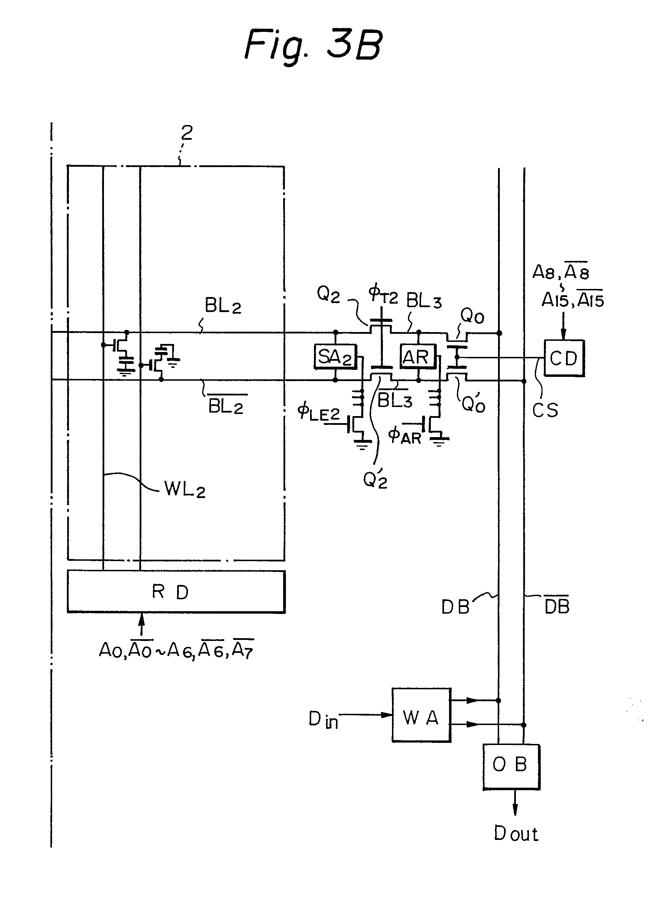

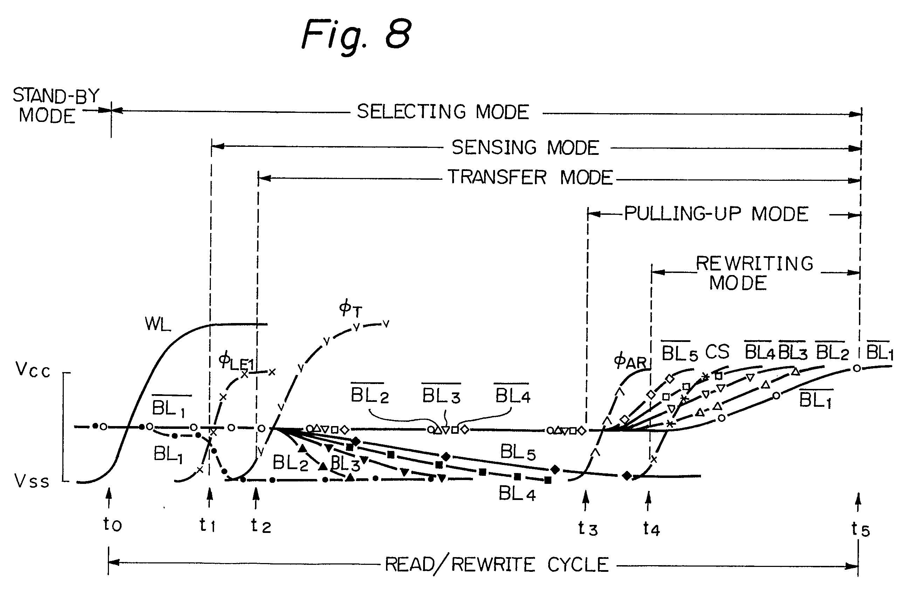

Further, in a dynamic RAM having a plurality of blocks, it is already known to construct one series of column decoders, for example, as shown in Fig. 7 of USP 4,122,546. The example given in Fig. 3 shows a two-block divided RAM having a one column configuration selected by a column decoder CD. In Fig. 3, $BL_1$ and $BL_2$ are partial bit lines formed by dividing one bit line and $\overline{BL}_1$ and $BL_2$ are complementary partial bit lines formed by dividing another bit line, and each of them is paired with the partial bit lines $BL_1$ and $BL_2$. In this case, one bit line is divided into two, and accordingly, the C ratio is halved. As a result, the initial difference in potential (before the sense amplifier operates) becomes large. Linked between the partial bit lines $BL_1$ and $BL_2$ ($BL_1$ to $\overline{BL}_2$) are transfer gates $Q_1$ and $Q_2$ ($Q_1'$ and $Q_2'$). Provided in each of the parts of the bit lines is a sense amplifier $SA_1$ ($SA_2$). Reference AR designates an active restore circuit provided between the bit lines $BL_3$ and $\overline{BL}_3$. Provided between the bit lines $BL_3$ and $\overline{BL}_3$ and the data buses DB and $\overline{DB}$ are transfer gates $Q_0$ and $Q_0'$ selected by a column select signal CS from the column decoder CD.

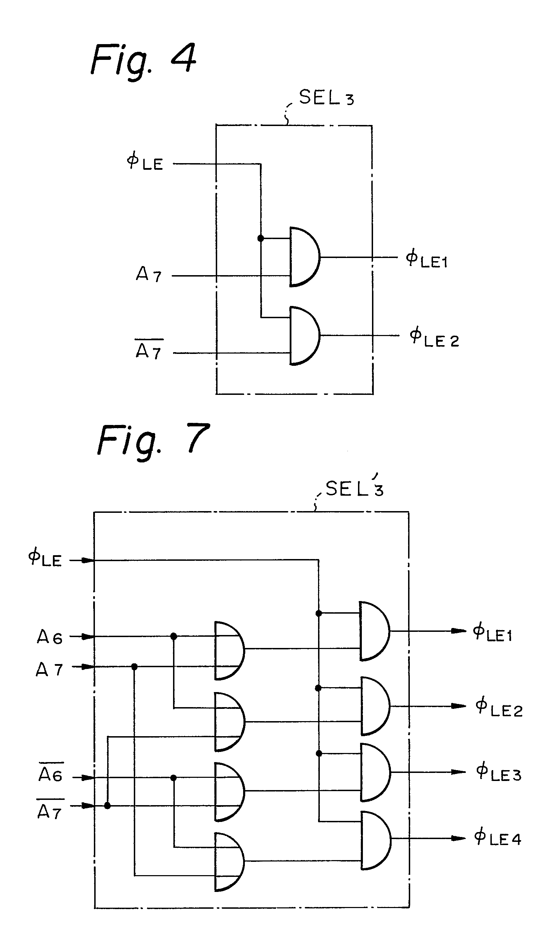

References $\phi_{LE1}$ and $\phi_{LE2}$ are clocks for enabling the sense amplifiers $SA_1$ and $SA_2$; $\phi_{T1}$ and $\phi_{T2}$ are clock signals for turning ON the transfer gates $Q_1$ and $Q_1'$ ($Q_2$ and $Q_2'$); and $\phi_{AR}$ is a clock signal for enabling the active restore circuit AR. The clock signals $\phi_{LE1}$ and $\phi_{LE2}$ are generated by a selection circuit $SEL_3$, which is illustrated in detail in Fig. 4.

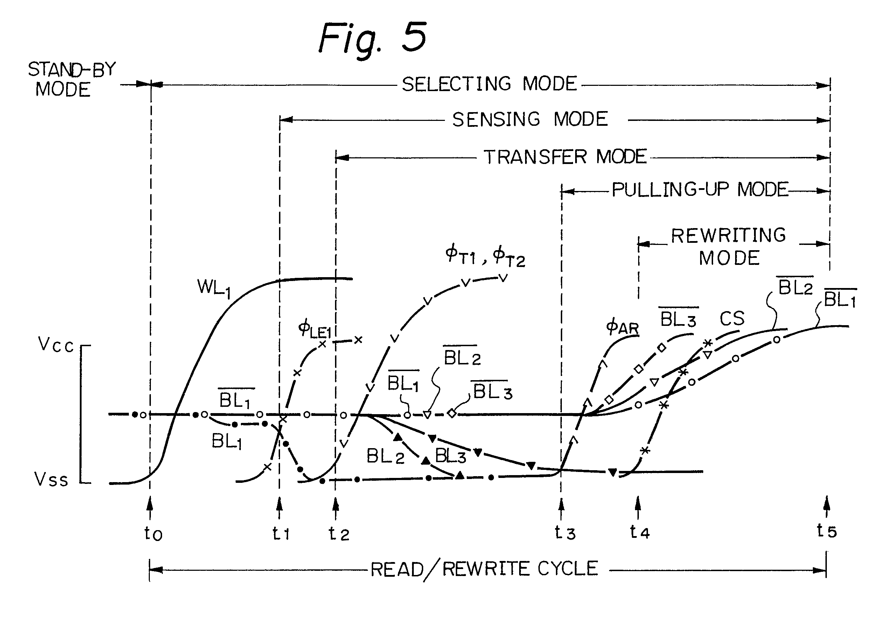

The operation of the circuit of Fig. 3 will be explained with reference to Fig. 5. In a stand-by mode, the partial bit lines $BL_1$, $\overline{BL}_1$, $BL_2$, and $\overline{BL}_2$ are precharged at $V_{cc}/2$ by the precharging circuits (not shown). When the data "1" is stored in the memory cell MC, the capacitor of the memory cell MC is charged at $V_{cc}$, and when the data "0" is stored in the memory cell MC, the capacitor of the memory cell MC is charged at $V_{ss}$ (= 0). During a selecting mode, at time $t_0$ , in order to select the word line $WL_1$ , the potential at the word line $WL_1$ is raised to a level higher than $V_{cc}$. As a result, the data of the memory cell MC appears at the bit lines $BL_1$ or $\overline{BL}_1$ , thus generating a very small difference between the bit lines $BL_1$ and $\overline{BL}_1$ ($\overline{BL}_1$ > $BL_1$ , for example). Then, at time $t_1$ , the clock signal $\phi_{LE1}$ is generated so as to activate the sense amplifier $SA_1$. In this case, the sense amplifier $SA_1$ comprises a flip-flop in which one transistor is turned ON and the other transistor is turned OFF by the very small difference in potential. The bit line $BL_1$ connected to the turned-ON transistor falls to $V_{ss}$ level, thus generating a large difference in potential between the bit lines $BL_1$ and $\overline{BL}_1$. Thus, at time $t_2$ , when such a large difference occurs between the bit lines $BL_1$ and $\overline{BL}_1$ , both the clock signals $\phi_{T1}$ and $\phi_{T2}$ are pulled up to turn ON the transfer gates $Q_1$ and $Q_1'$ ($Q_2$ and $Q_2'$). Therefore, the potentials at the bit lines $BL_1$ and $\overline{BL}_1$ are transmitted sequentially from the bit lines $BL_1$ and $\overline{BL}_1$ to the bit lines $BL_2$ and $\overline{BL}_2$. Then, at time $t_3$ , when a difference is generated in potential between the final bit lines $BL_3$ and $\overline{BL}_3$ , the clock signal $\phi_{AR}$ is pulled up to operate the active restore circuit AR.

The active restore circuit AR pulls the higher one of the potentials at the bit lines $BL_3$ and $\overline{BL}_3$ (in this case, $\overline{BL}_3$) up to $V_{cc}$ , thereby amplifying the difference in potential between the bit lines $BL_3$ and $\overline{BL}_3$. After the operation of the active restore circuit AR is completed, at time $t_4$ , the column select signal CS is pulled up so as to turn on the transfer gates $Q_0$ and $Q_0'$. By the sequence of the above-mentioned operations, the data of the cell MC is read out to the data buses DB and $\overline{DB}$. Simultaneously, when the bit line $\overline{BL}_3$ rises up to $V_{cc}$ , the change in potential is transmitted therefrom via the transfer gates $Q_2'$ and $Q_1'$ in the

reverse direction to the bit line $\overline{BL}_1$ on the memory cell MC. That is, the potential at the bit line $\overline{BL}_1$ rises to $V_{cc}$. Thus, a re-writing operation upon the read cell MC is carried out by the potentials $\overline{BL}_1 = V_{cc}$ and $BL_1 = V_{ss}$. At time $t_5$ , the re-writing operation is completed.

In Fig. 3, however, since the read and re-writing operation has to be carried out by multi-steps such as the partial bit lines $BL_1$ $(\overline{BL}_1)$ and $BL_2$ $(\overline{BL}_2)$ and the transfer gates $Q_1$ $(Q_1')$ and $Q_2$ $(Q_2')$, the time period from $t_2$ to $t_3$ and the time period from $t_4$ to $t_5$ are long. Such long time periods are due to the fact that the transfer gates $Q_1$ $(Q_1')$ and $Q_2$ $(Q_2')$ cannot be large. That is, one reason for the limitation of size of the transfer gates is that the pitch of the cells is small because of the high integration, and in that the gate area of each of the transfer gates is preferably large in view of effectively carrying out the bootstrap effect. That is, the clock signals $\phi_{T1}$ and $\phi_{T2}$ for driving the transfer gates are pulled up to a potential higher than $V_{cc}$ as shown in Fig. 4. Since such a pulling-up operation is carried out by the bootstrap circuit (not shown), it is necessary to reduce the gate capacitance of the transfer gates.

As explained above, the transfer gates $Q_1$ $(Q_1')$ and $Q_2$ $(Q_2')$ are small in size, however, this reduces the value $g_m$ thereof, so that the ON-resistance thereof cannot be neglected. In addition, a large number of memory cells are connected to one bit line, thereby increasing the parasitic capacitance thereof. As a result, the ON-resistance of the transfer gates $Q_1$ $(Q_1')$ and $Q_2$ $(Q_2')$ and the parasitic capacitance of the partial bit lines form a large CR time constant circuit which reduces the change in potential. Therefore, in a configuration as shown in Fig. 3, in which data is read by multisteps and data is rewritten by multisteps, the read rewrite cycle is large.

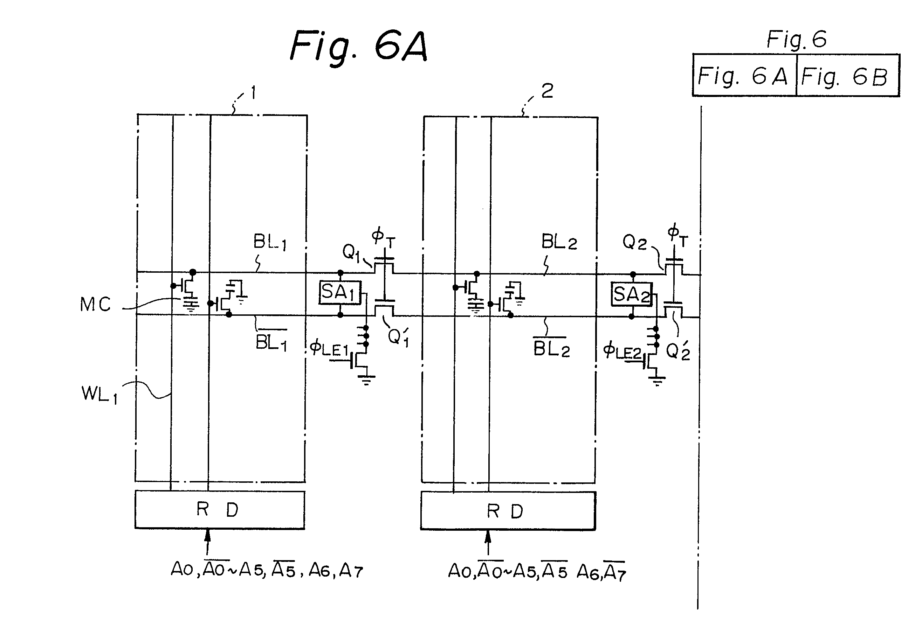

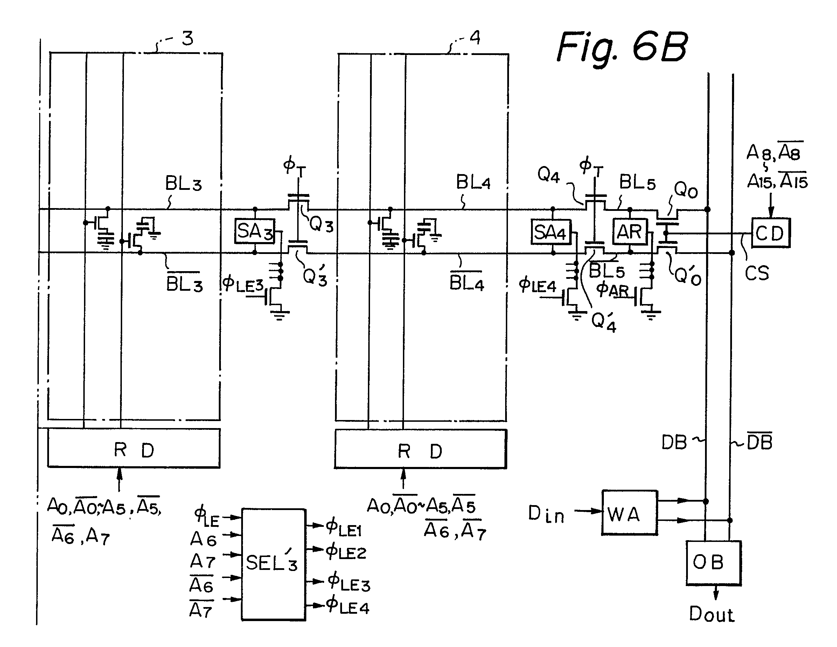

The configuration of Fig. 3 can be enlarged to a four-block divided RAM as illustrated in Fig. 6. That is, memory cells are divided into memory cell arrays 1, 2, 3, and 4. In addition, transfer gates $Q_3$, $Q_3'$, $Q_4$, $Q_4'$, and sense amplifiers $SA_3$ and $SA_4$ are added to the elements of Fig. 3. Also, a selection circuit $SEL_3'$ for generating the latch enable signals $\phi_{LE1}$, $\phi_{LE2}$, $\phi_{LE3}$, and $\phi_{LE4}$ as shown in Fig. 7 is used instead of the selection circuit $SEL_3$ of Fig. 3. In Fig. 6, one bit line is divided into four, and accordingly, the C ratio is quartered. As a result, the initial difference in potential (before the sense amplifier operates) becomes large.

The operation of the circuit of Fig. 6 is shown in Fig. 8 which is similar to Fig. 5. That is, at time $t_o$, when all the clock signals $\phi_{T1}$ to $\phi_{T4}$ are pulled up to turn ON the transfer gates $Q_1$ ($Q_1'$) to $Q_4$ ($Q_4'$), the potentials at the bit lines $BL_1$ and $\overline{BL}_1$ are transmitted sequentially from the bit lines $BL_2$ and $\overline{BL}_2$, via $BL_3$ and $\overline{BL}_3$, and $BL_4$ and $\overline{BL}_4$ to $BL_0$ and $\overline{BL}_0$. Then at time $t_3$, when a difference is generated in potential between the final bit lines $BL_0$ and $\overline{BL}_0$, the clock signal $\phi_{AR}$ is pulled up to operate the active restore circuit AR. Thus, compared with Fig. 5, the time period from $t_2$ to $t_3$ becomes long due to the increased number of blocks. Further, the time period from $t_4$ to $t_5$ for a rewriting mode also becomes long due to the increased number of blocks. Thus, the read/rewrite time period becomes remarkably large when the number of blocks is increased.

Further, it is impossible to apply the circuit of Figs. 3 and 6 to a RAM having open bit lines as illustrated in Fig. 2, which is fatally disadvantageous.

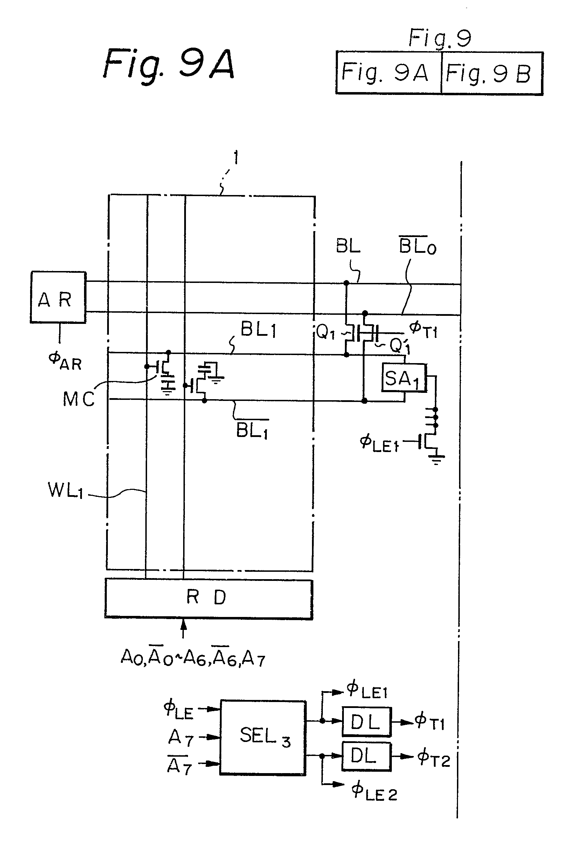

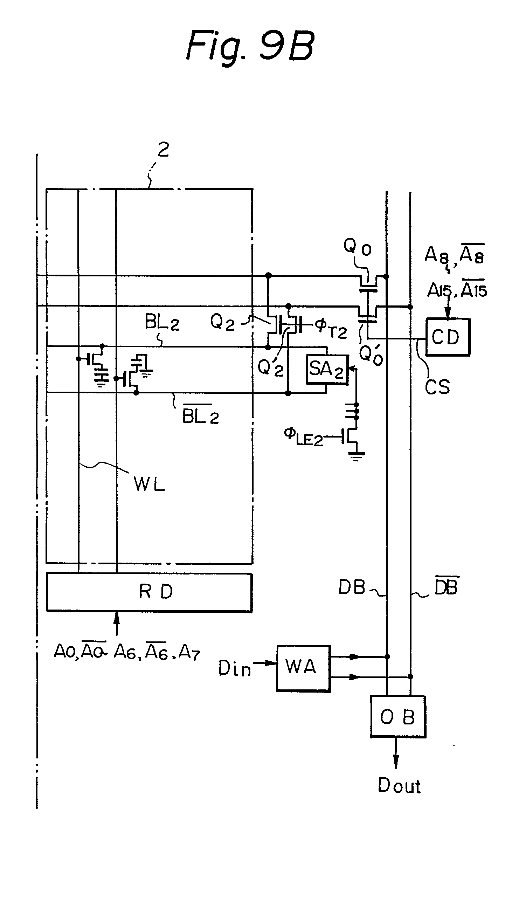

In Fig. 9, which illustrates a first embodiment of the present invention, a two-block divided RAM having folded bit lines is illustrated. In Fig. 9, a pair of bus bit lines $BL_0$ and $\overline{BL}_0$ are provided commonly for the partial bit lines $BL_1$ and $\overline{BL}_1$ of the memory cell array 1 and the partial bit lines $BL_2$ and $\overline{BL}_2$ of the memory cell array 2. Linked between the partial bit lines $BL_1$ and $\overline{BL}_1$ , and the bus bit lines $BL_0$ and $\overline{BL}_0$ are the transfer gates $Q_1$ and $Q_1'$. Also linked between the partial bit lines $BL_2$ and $\overline{BL}_2$ , and the bus bit lines $BL_0$ and $\overline{BL}_0$ are the transfer gates $Q_2$ and $Q_2'$. Note that the bit lines $BL_1$ and $\overline{BL}_1$ , and the bit lines $BL_2$ and $\overline{BL}_2$ have the same column address.

References $\phi_{T1}$ and $\phi_{T2}$ are clock signals for activating the transfer gates $Q_1$ and $Q_1'$; and $Q_2$ and $Q_2'$, respectively, and are obtained by delaying the latch enable signals $\phi_{LE1}$ and $\phi_{LE2}$ , respectively.

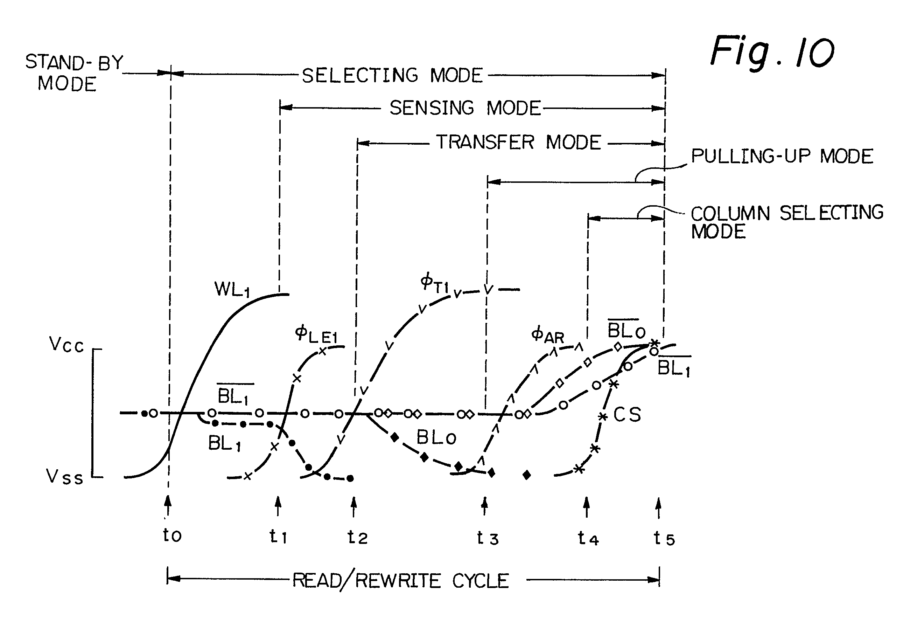

The operation of the circuit of Fig. 9 will be explained with reference to Fig. 10. In a stand-by mode, the partial bit lines $BL_1$ , $\overline{BL}_1$ , $BL_2$ , and $\overline{BL}_2$ are precharged at $V_{cc}/2$ by the precharging circuits (not shown). When the data "1" is stored in the memory cell MC, the capacitor of the memory cell MC is charged at $V_{cc}$ , and when the data "0" is stored in the memory cell MC, the capacitor of the memory cell MC is charged at $V_{ss}$ (= 0). During a selecting mode, at time $t_0$ , in order to select the word line $WL_1$ , the potential at the word line $WL_1$ is raised to a level higher than $V_{cc}$. As a result, the data of the memory cell MC appears at the bit lines $BL_1$ and $\overline{BL}_1$ , thus generating a very small difference between the bit lines $BL_1$ and $\overline{BL}_1$ ($\overline{BL}_1$ > $BL_1$ , for example). Then, at time $t_1$ , the clock signal $\phi_{LE1}$ is generated so as to activate the sense amplifier $SA_1$. As a result, the bit line $BL_1$ connected to the turned-ON transistor falls to $V_{ss}$ level, thus generating a large difference in potential between the bit lines $BL_1$ and $\overline{BL}_1$. Thus, at time $t_2$ , when such a large difference occurs between the bit lines $BL_1$ and $\overline{BL}_1$ , only one of the clock signals $\phi_{T1}$ and $\phi_{T2}$ is pulled up to turn ON the transfer gates $Q_1$ and $Q_1'$. Therefore, the potentials at the bit lines $BL_1$ and $\overline{BL}_1$ are transmitted to the bit

lines BL and $\overline{BL}_0$. Then, at time $t_3$ , when a difference is generated in potential between the bit lines $BL_0$ and $\overline{BL}_0$ , the clock signal $\phi_{AR}$ is pulled up to operate the active restore circuit AR. After the operation of the active restore circuit AR is completed, at time $t_4$ , the column select signal CS is pulled up so as to turn on the transfer gates $Q_0$ and $Q_0{}'$. Thus, the data of the cell MC is read out to the data buses DB and $\overline{DB}$. Simultaneously, when the bit line $\overline{BL}_0$ rises up to $V_{cc}$ , the change in potential is transmitted to the bit line $\overline{BL}_1$ on the memory cell MC. That is, the potential at the bit line $\overline{BL}_1$ rises to $V_{cc}$. Thus, a re-writing operation upon the read cell MC is carried out by the potentials $\overline{BL}_1 = V_{cc}$ and $BL_1 = V_{ss}$. At time $t_5$ , the re-writing operation is completed.

Since the time period from $t_1$ and $t_2$ of Fig. 10 includes the delay time caused by only one stage of the transfer gates $Q_1$ and $Q_1{}'$, this time period is remarkably shortened as compared with the corresponding time period from $t_2$ to $t_3$ of Fig. 5. Note that the circuit of Fig. 9 can be applied to a multiple-block configuration. Also, in this case, the time period from $t_1$ to $t_2$ is substantially the same.

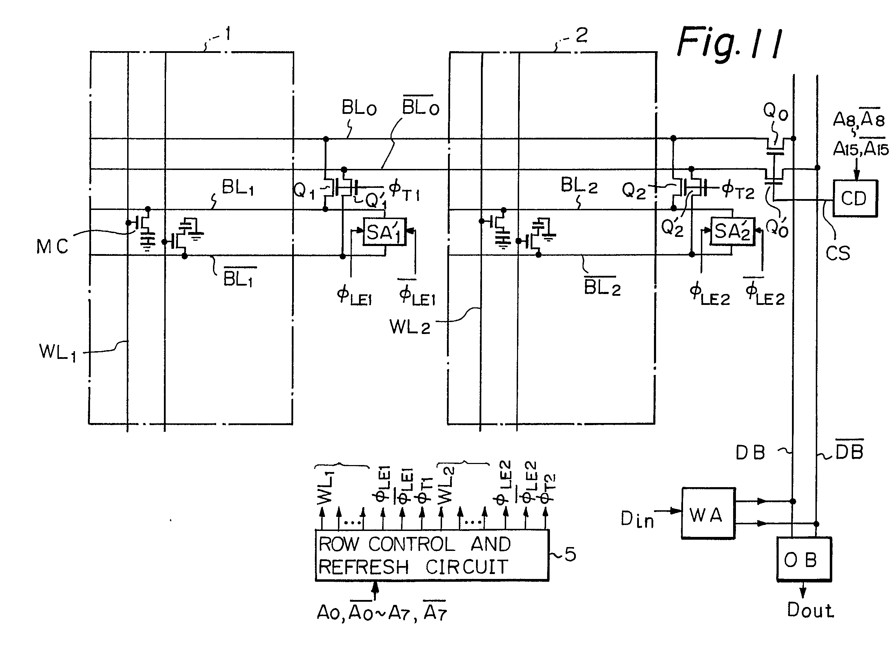

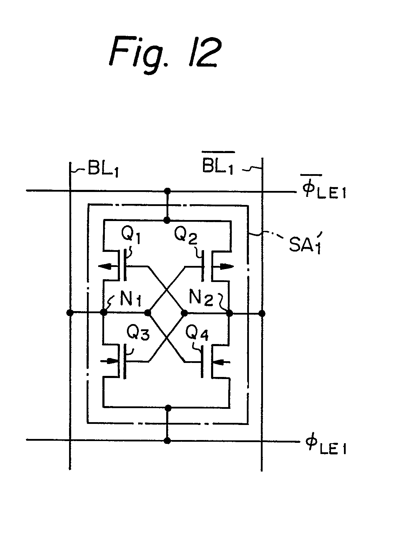

In Fig. 11, which illustrates a second embodiment of the present invention, sense amplifiers $SA_1{}'$ and $SA_2{}'$ incorporating active restore functions are provided instead of the sense amplifiers $SA_1$ and $SA_2$. For example, as illustrated in Fig. 12, the sense amplifier $SA_1{}'$ is comprised of cross-coupled P-channel MOS transistors $Q_1$ and $Q_2$ , and cross-coupled N-channel MOS transistors $Q_3$ and $Q_4$. In this case, the transistors $Q_1$ and $Q_2$ form a flip-flop which pulls up the higher one of the potentials at the nodes $N_1$ and $N_2$ , i.e., at the bit lines $BL_1$ and $\overline{BL}_1$ , when the clock signal $\overline{\phi}_{LE1}$ is pulled up. Thus, the transistors $Q_1$ and $Q_2$ carry out an active restore function. Contrary to this, the transistors $Q_3$ and $Q_4$ form also a flip-flop which pulls down the lower one of the potentials at the nodes $N_1$ and $N_2$ , i.e., at the bit lines $BL_1$ and $\overline{BL}_1$ , when the clock signal $\phi_{LE1}$ is pulled down. Thus, the transistors $Q_3$ and $Q_4$ carry out an original sense amplifying function.

The clock signals $\phi_{LE1}$ , $\overline{\phi}_{LE1}$ , $\phi_{LE2}$ , $\overline{\phi}_{LE2}$ , $\phi_{T1}$ , $\phi_{T2}$ are generated by a row control and refresh circuit 5 which receives the row address signals $A_0$ , $\overline{A}_0$ to $A_7$ , $\overline{A}_7$.

In the row control and refresh circuit 5, one word line of the memory cell array 1 is carried out by using the row address signals $A_0$ , $\overline{A}_0$ , ..., $A_6$ , $\overline{A}_6$ , and $A_7$ , while one word line of the memory cell array 1 is carried out by using the row address signals $A_0$ , $\overline{A}_0$ , ..., $A_6$ , $\overline{A}_6$ , and $\overline{A}_7$. In a refresh mode, the potentials of the row address signals $A_7$ and $\overline{A}_7$ are both caused to be low within the circuit 5, thereby selecting two word lines such as $WL_1$ and $WL_2$.

In an access mode such as a read mode or a write mode, only one of the memory cell arrays 1 and 2 is operated. That is, data of a memory cell of the array 1 or 2 is transmitted from the respective partial bit lines via the respective bus bit lines to the data buses DB and DB. Selection of the memory cell arrays 1 and 2 is carried out by the row address signals $A_7$ and $\overline{A}_7$.

On the other hand, it is always necessary to perform a refresh operation upon the memory cells of a dynamic RAM, in order to avoid the destruction of information stored in the memory cells due to the current leak. The number of refresh operations can be reduced by simultaneously activating a plurality of sense amplifiers and a plurality of memory cells. For this purpose, in a refresh mode, both of the memory cell arrays 1 and 2 are activated. In this case, two word lines such as $WL_1$ and $WL_2$ are selected, and the sense amplifiers $SA_1$ and $SA_2$ are activated, but the clock signals $\phi_{T1}$ and $\phi_{T2}$ are not activated. Note that only one of the clock signals $\phi_{T1}$ and $\phi_{T2}$ can be also activated.

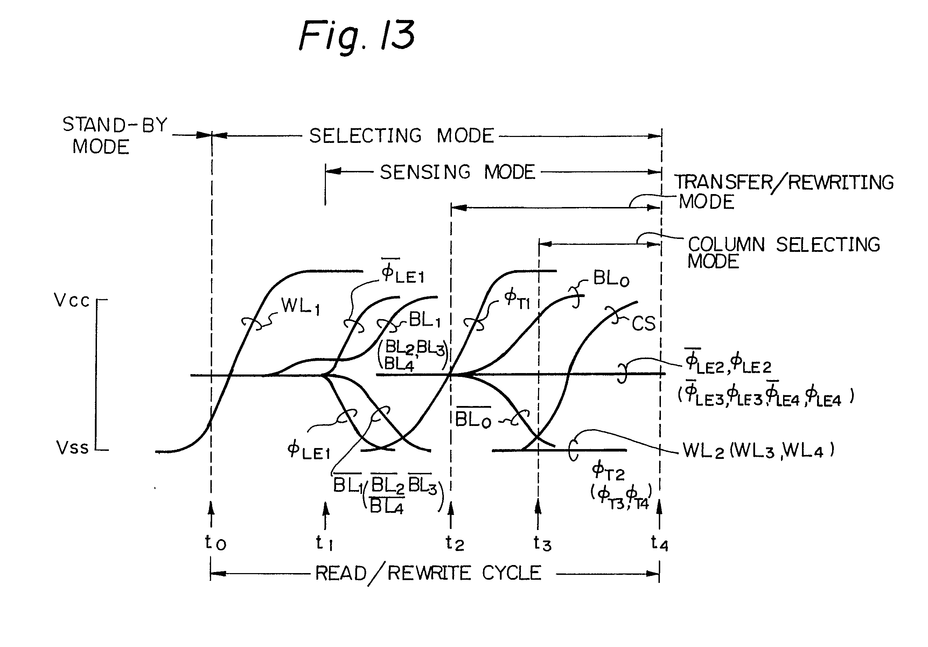

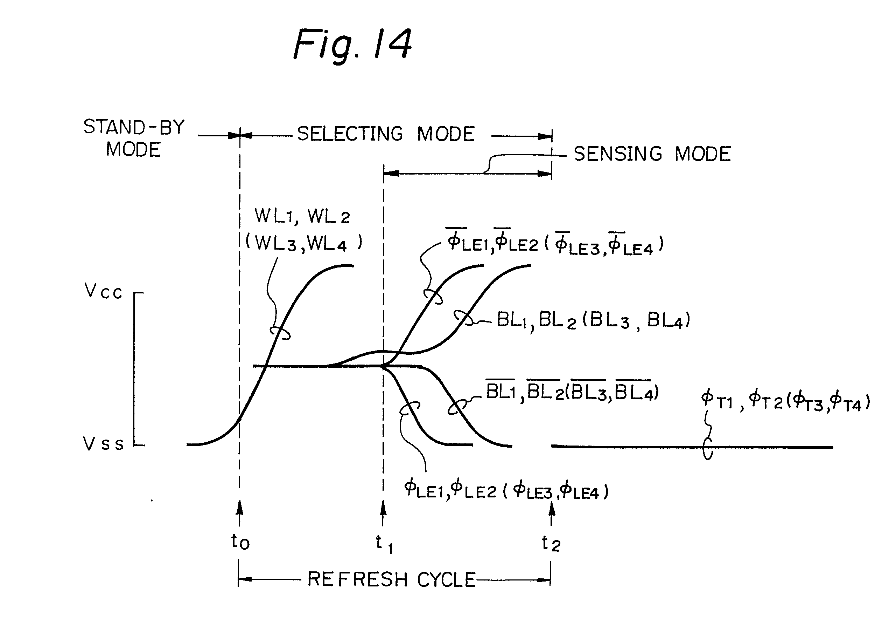

The operation of the circuit of Fig. 11 will be explained with reference to Figs. 13 and 14.

Referring to Fig. 13, which shows a read/rewrite operation, it is assumed that the capacitor of the memory cell MC is charged at $V_{cc}$. Then at time $t_0$, when the control enters a selecting mode for the memory cell MC, the potential at the word line $WL_1$ is raised to a level higher than $V_{cc}$, thus generating a very small difference in potential between the partial bit lines $BL_1$ and $\overline{BL}_1$. In this case, the potential is higher at the partial bit line $BL_1$ than at the partial bit line $\overline{BL}_1$. Then at time $t_1$, the clock signal $\overline{\phi}_{LE1}$ is pulled up to $V_{cc}$, and simultaneously, the clock signal $\phi_{LE1}$ is pulled down to $V_{ss}$, thereby activating the sense amplifier $SA_1'$. As explained above, the sense amplifier $SA_1'$ also incorporates an active restore function, the higher of the potentials at the partial bit lines $BL_1$ and $\overline{BL}_1$ is pulled up, and simultaneously, the lower potential is pulled down. Then at time $t_2$, the clock signal $\phi_{T1}$ is pulled up to a level higher than $V_{cc}$, so as to turn ON the transfer gates $Q_1$ and $Q_1'$, the potentials at the partial bit lines $BL_1$ and $\overline{BL}_1$ are transmitted via the turned-ON transfer gates $Q_1$ and $Q_1'$ to the bus bit lines $BL_0$ and $\overline{BL}_0$. That is, the potentials at the bus bit lines $BL_0$ and $\overline{BL}_0$ follow the potentials at the partial bit lines $BL_1$ and $\overline{BL}_1$, respectively. Then, at time $t_3$, the column selection signal CS is pulled up by the column decoder CD to $V_{cc}$ so as to turn ON the transfer gates $Q_0$ and $Q_0'$, the potentials at the bus bit lines $BL_0$ and $\overline{BL}_0$ are transferred via the turned-ON transfer gates $Q_0$ and $Q_0'$ to the common data buses DB and $\overline{DB}$, respectively. Thus, a read/rewrite operation for the memory cell MC is completed. In such a read/rewrite operation, the clock signals $\phi_{LE2}$ and $\overline{\phi}_{LE2}$ remain at $V_{cc}/2$, since none of the memory cells within the memory cell array 2 are selected. Also, the clock signal $\phi_{T2}$ remains at $V_{ss}$ , since it is unnecessary to turn ON the transfer gates $Q_2$ and $Q_2'$.

Since the time period from $t_1$ to $t_2$ of Fig. 13 includes the delay time caused by only one stage of the transfer gates $Q_1$ and $Q_1'$, this time period is remarkably shortened as compared with the corresponding time period from $t_2$ to $t_3$ of Fig. 5. Further, since an active restore operation, i.e., a pulling-up operation, is carried out simultaneously with the sensing operation, the time period from $t_3$ to $t_4$ of Fig. 5 is eliminated, so that the read/rewrite time period can be remarkably small as compared with the circuit of Fig. 3.

In addition, in Fig. 11, since the common data buses DB and $\overline{DB}$ are provided commonly for the blocks, i.e., the memory cell arrays 1 and 2, only one write amplifier WA is needed for writing data $D_{in}$ , and only one output buffer circuit OB is needed for reading data $D_{out}$. Note that a write/read control operation is carried out by the write control circuit (not shown).

Referring to Fig. 14, which shows a refresh operation, at time $t_0$ , the potential at the word line $WL_1$ and the potential at the word line $WL_2$ are both raised to a level higher than $V_{cc}$. As a result, a very small difference in potential is generated between the partial bit lines $BL_1$ and $\overline{BL}_1$ , and a very small difference in potential is also generated between the partial bit lines $BL_2$ and $\overline{BL}_2$. Then, at time $t_1$ , the clock signals $\overline{\phi}_{LE1}$ and $\overline{\phi}_{LE2}$ are pulled up to $V_{cc}$ , and simultaneously, the clock signals $\phi_{LE1}$ and $\phi_{LE2}$ are pulled down to $V_{ss}$. As a result, the higher of the potentials at the partial bit lines $BL_1$ and $\overline{BL}_1$ is pulled up, and simultaneously, the lower potential is pulled down. Similarly, the higher of the potentials at the partial bit lines $BL_2$ and $\overline{BL}_2$ is pulled up, and simultaneously, the lower potential is pulled down. Thus, at time $t_2$ , a refresh operation

is completed. In such a refresh operation, since no transfer of data is required from the partial bit lines $BL_1$ and $\overline{BL}_1$ (or $BL_2$ and $\overline{BL}_2$) to the bus bit lines $BL_0$ and $\overline{BL}_0$ , it is unnecessary to pull up the clock signals $\phi_{T1}$ and $\phi_{T2}$. That is, the time period from $t_2$ to $t_4$ for a transfer mode and a column selecting mode becomes unnecessary for a refresh operation.

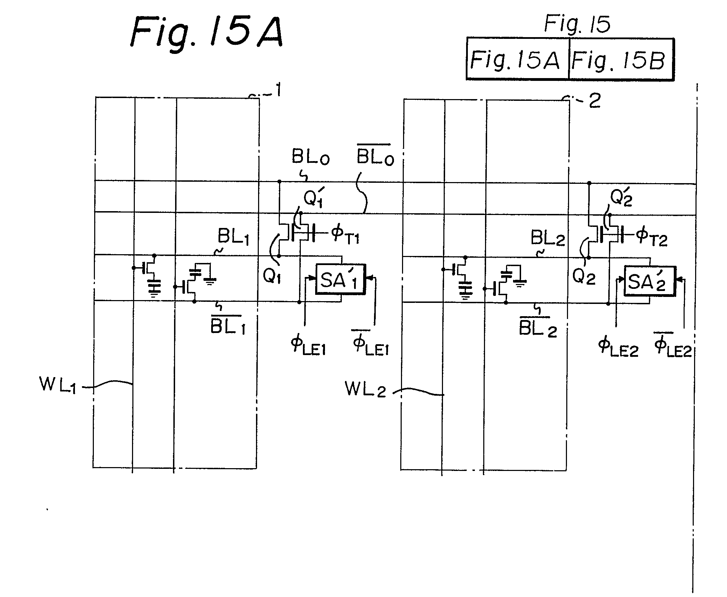

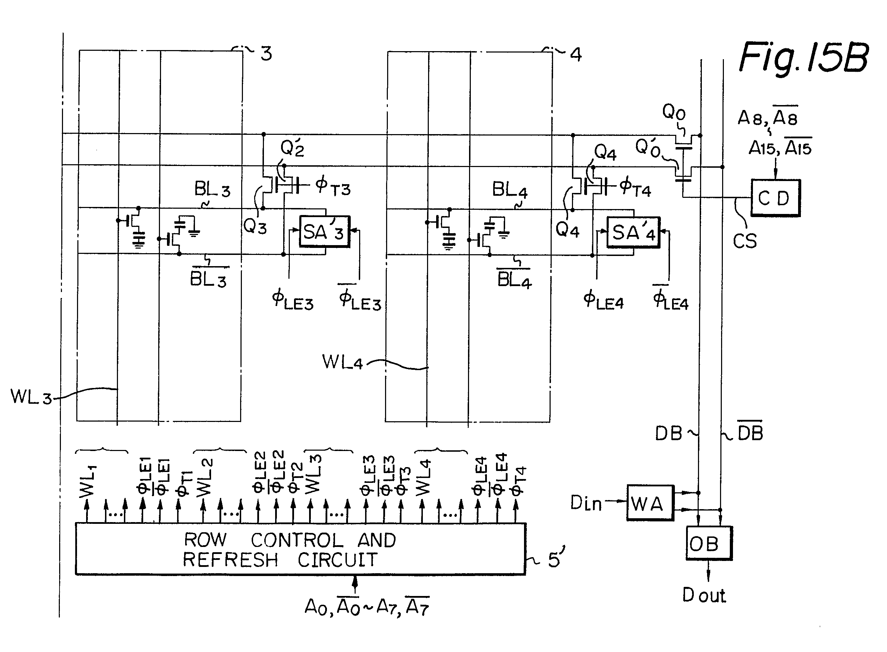

The configuration of Fig. 11 can be enlarged to a four-block divided RAM which is illustrated in Fig. 15. That is, memory cells are divided into memory cell , arrays 1, 2, 3, and 4. In addition, transfer gates $Q_3$ , $Q_3'$, $Q_4$ , $Q_4'$, and sense amplifiers $SA_3'$ and $SA_4'$ are added to the elements of Fig. 11. Also, a row control and refresh circuit 5' of the row control and refresh circuit 5 of Fig. 11. In Fig. 15, one bit line is divided into four, and accordingly, the C ratio is quartered. As a result, the initial difference in potential (before the sense amplifier operates) becomes large.

The operation of the circuit of Fig. 15 is similar to that of the circuit 9 (see brackets of Fig. 13). That is, in a read/rewrite operation, the read/rewrite time period is also dependent upon only one stage of the transfer gates such as $Q_1$ and $Q_1'$, and accordingly, this read/rewrite time period is substantially the same as the time period from $t_0$ to $t_4$ of Fig. 13. Also, in a refresh operation (see brackets of Fig. 14), the refresh time period seems about the same but is actually a little smaller, since the C ratio is small as compared with the circuit of Fig. 11.

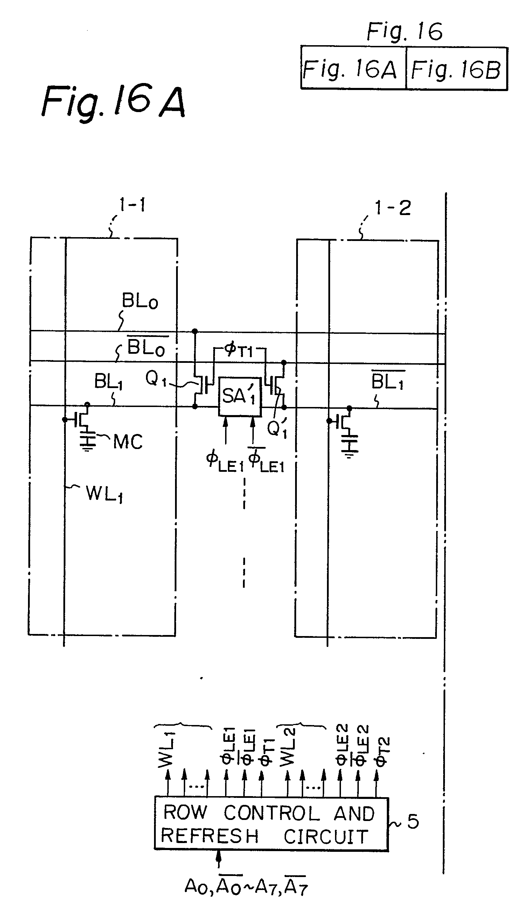

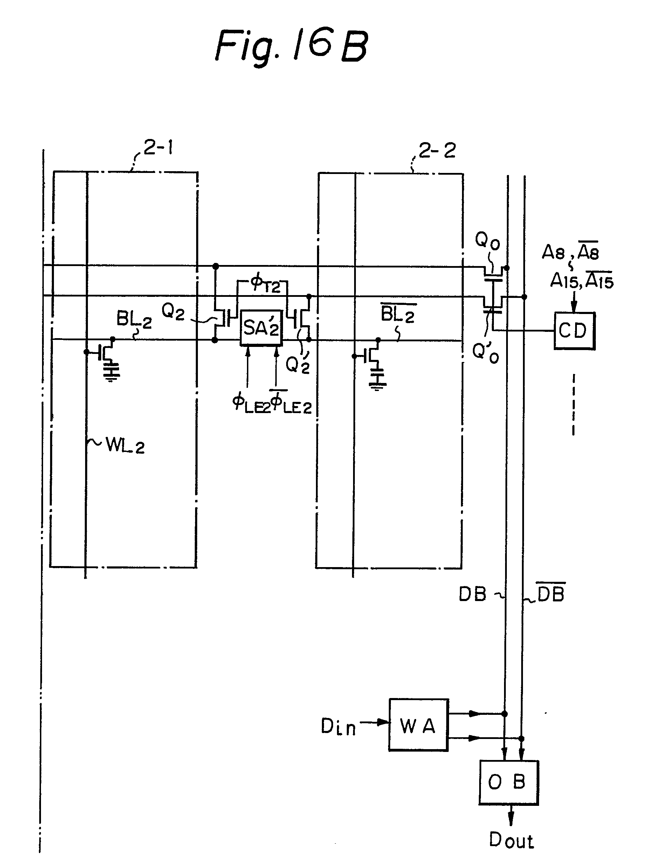

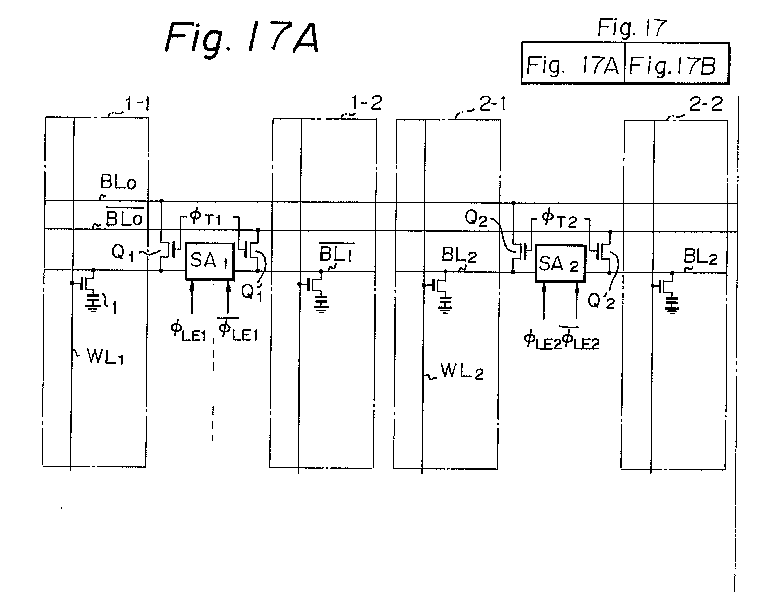

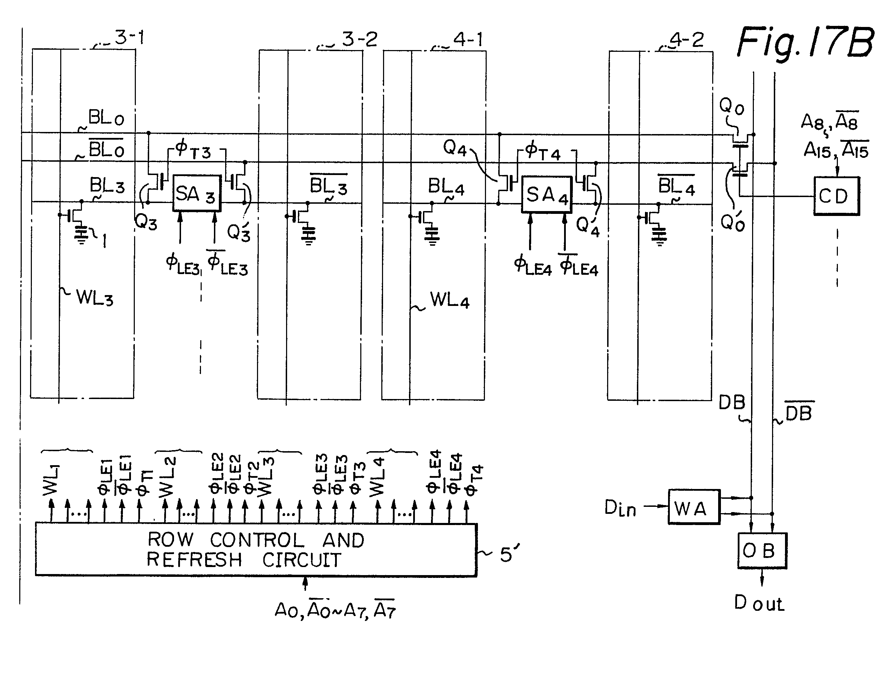

The present invention is applied to a dynamic RAM having open bit lines, as shown in Figs. 16 and 17. Figure 16 illustrates a two-block divided RAM, and Fig. 17 illustrates a four-block divided RAM. In Figs. 16 and 17, a series of sense amplifiers $SA_1'$ ($SA_2'$, $SA_3'$, $SA_4'$) are provided between the memory cell arrays 1-1 and 1-2 (2-1 and 2-2, 3-1 and 3-2, 4-1 and 4-2). The other portions of Figs. 16 and 17 are the same as those of Figs. 11 and 15, respectively.  In addition, the operations of the circuits of Figs. 16 and 17 are the same as those of the circuits of Figs. 11 and 15, respectively.

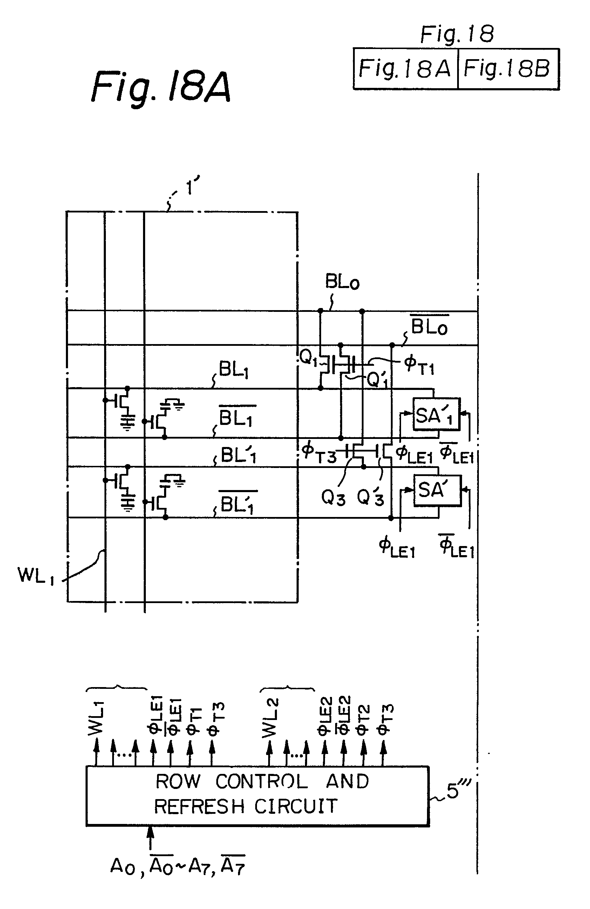

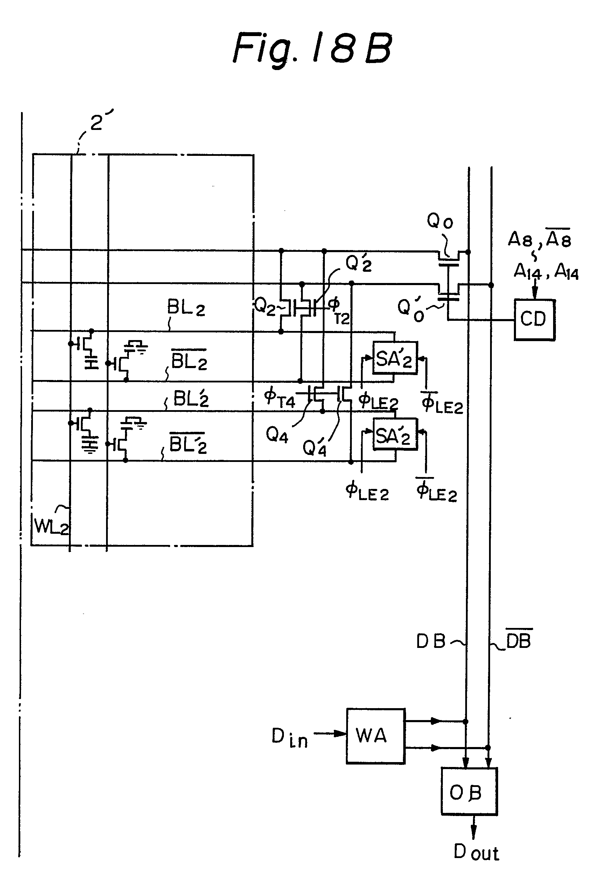

In Figs. 18, 19, and 20, which illustrate other embodiments of the present invention, a pair of bus bit lines are provided for four pairs of partial bit lines in a two-block divided RAM.  That is, a pair of bus bit lines $BL_0$ and $\overline{BL}_0$ are provided for four pairs of bit lines $\overline{BL}_1$ , $BL_1$; $\overline{BL}_1'$, $BL_1'$; $BL_2$ , $\overline{BL}_2$; and $BL_2'$, $\overline{BL}_2'$.

In Fig. 18, which illustrates a RAM having folded bit lines, in a read/rewrite operation for a memory cell, one word line such as $WL_1$ within the memory cell array 1' or one word line such as $WL_2$ within the memory cell array 2' is selected, and a series of the sense amplifiers $SA_1'$ or a series of the sense amplifiers $SA_2'$ are activated.  Further, only one pair of the partial bit lines $BL_1$ , $\overline{BL}_1$ , $BL_1'$, $\overline{BL}_1'$; $BL_2$ , $\overline{BL}_2$; and $BL_3$ , $\overline{BL}_3'$ are selected by one of the clock signals $\phi_{T1}$ , $\phi_{T2}$ , $\phi_{T3}$ , and $\phi_{T4}$ and are connected to the bus bit lines $BL_0$ and $\overline{BL}_0$.  Contrary to this, in a refresh mode, one word line such as $WL_1$ within the memory cell array 1' and one word line such as $WL_2$ within the memory cell array 2' are selected, and a series of the sense amplifiers $SA_1'$ and a series of the sense amplifiers $SA_2'$ are activated.  However, no clock signals $\phi_{T1}$ , $\phi_{T2}$ , $\phi_{T3}$ , and $\phi_{T4}$ are generated, and accordingly, none of the partial bit lines $BL_1$ , $\overline{BL}_1$ , $BL_1'$, $\overline{BL}_1'$; $BL_2$ , $\overline{BL}_2$; and $BL_3$ , $\overline{BL}_3'$ are connected to the bus bit lines $BL_0$ and $\overline{BL}_0$.

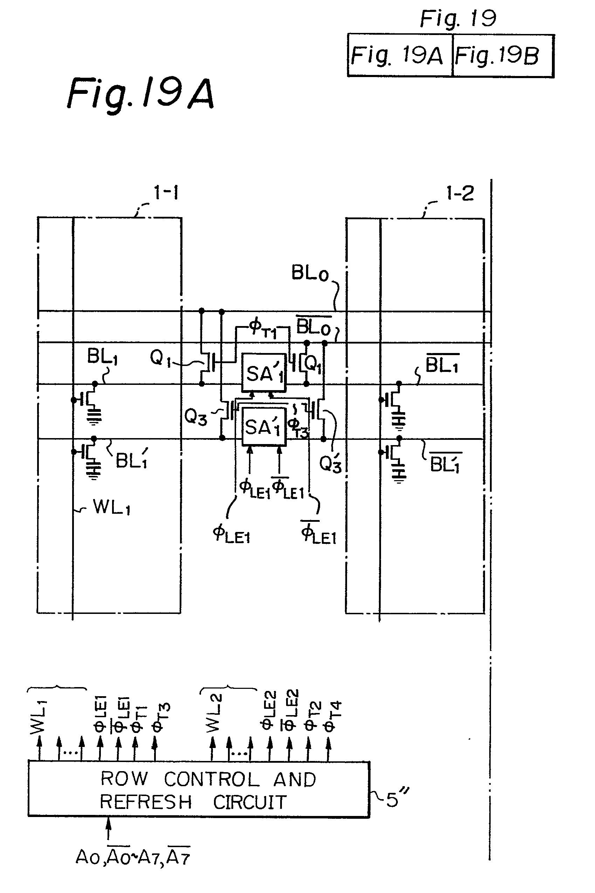

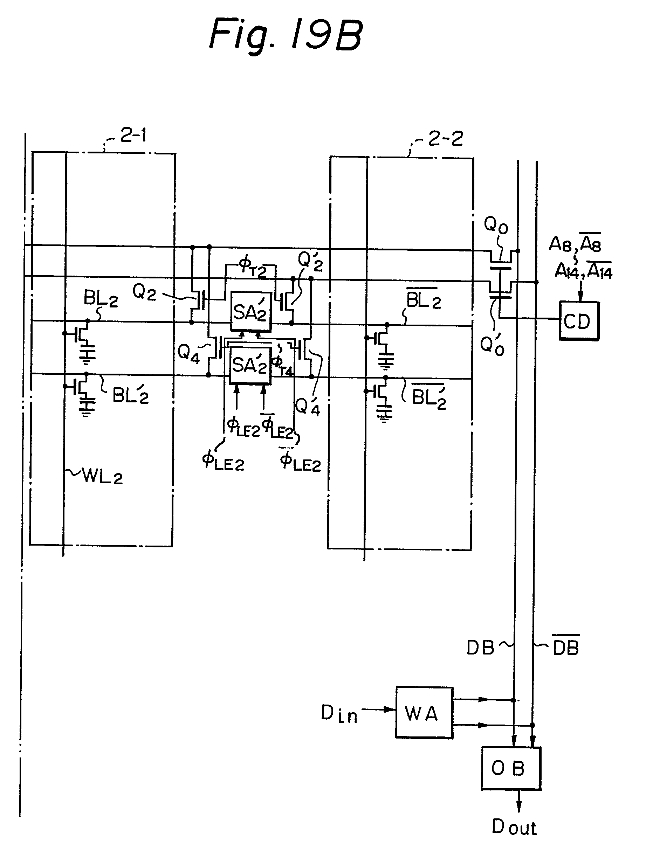

Figure 19 illustrates a RAM using open bit lines, which has almost the same configuration as that of Fig. 18.

In the circuits of Figs. 18 and 19, the clock signals $\phi_{T1}$ , $\phi_{T2}$ , $\phi_{T3}$ , and $\phi_{T4}$ for connecting the partial bit lines to the bus bit lines are generated by the row addresses $A_0$ , $\bar{A}_0$ to $A_7$ , $\bar{A}_7$ , not by the column addresses $A_8$, $\bar{A}_8$ to $A_{15}$ , $\bar{A}_{15}$. This avoids the disadvantage wherein the connection of the partial bit lines to the bus bit lines cannot be carried out prior to the determination of the column addresses, if the above-mentioned clock signals are generated by the column addresses. Therefore, in the row control and refresh circuit 5"' of Figs. 18 and 19, in a read/rewrite operation among the row addresses $A_0$ to $A_7$ , the word lines are decoded by the address $A_0$ to $A_5$ , and the selection of the connection of the bus bit lines is carried out by the addresses $A_6$ and $A_7$. As a result, as compared with the embodiments of Figs. 11 and 16, the number of cells per one bit line is halved while the number of cells along the word line direction is doubled. That is, in Figs. 11 and 16, one block is constructed by 256 word lines x 256 bit lines, while in Figs. 16 and 17, one block is constructed by 128 word lines x 512 bit lines. Since only 256 bits of the 512 bit lines can be connected to the bus bit lines, the column width of each bus bit line is the same as in the cases of Figs. 11 and 16.

As explained above, one block is constructed by a 128 x 512 cell configuration, and accordingly, the chip has a very long shape. In order to avoid this, it is preferable to take the following measures:

i) to modify the cell configuration by changing the ratio of the lengthwise dimension to the crosswise dimension of a cell, or

ii) to arrange the decoder at the center of the cell arrays, so that the cell arrays on each side are selected by the column addresses. In the latter case, in Figs. 18 and 19, the entire configuration is divided into an upper portion and a lower portion, and the upper portion is rotated by 180° and is arranged on the right side of the lower portion. Thus, the column decoders are common to both of the portions. Thus, when the column decoders are common to the portions (the upper and lower portions prior to the division thereof), the column addresses ($A_8$ to $A_{14}$) are effective for the 128 bits, and therefore, another column address bit $A_{15}$ is used for selecting the portions. Thus, it is possible by two bits of the row addresses to select and connect the partial bit lines to the bus bit lines.

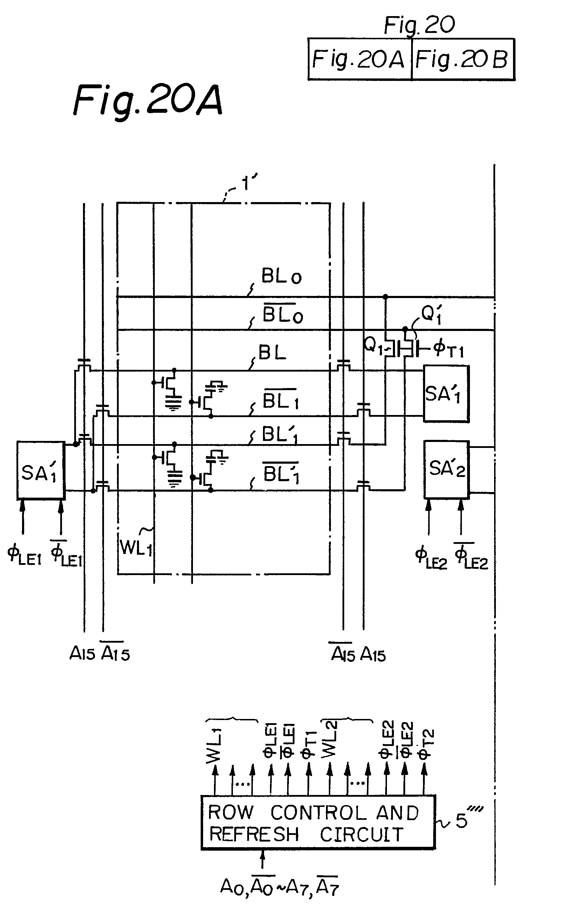

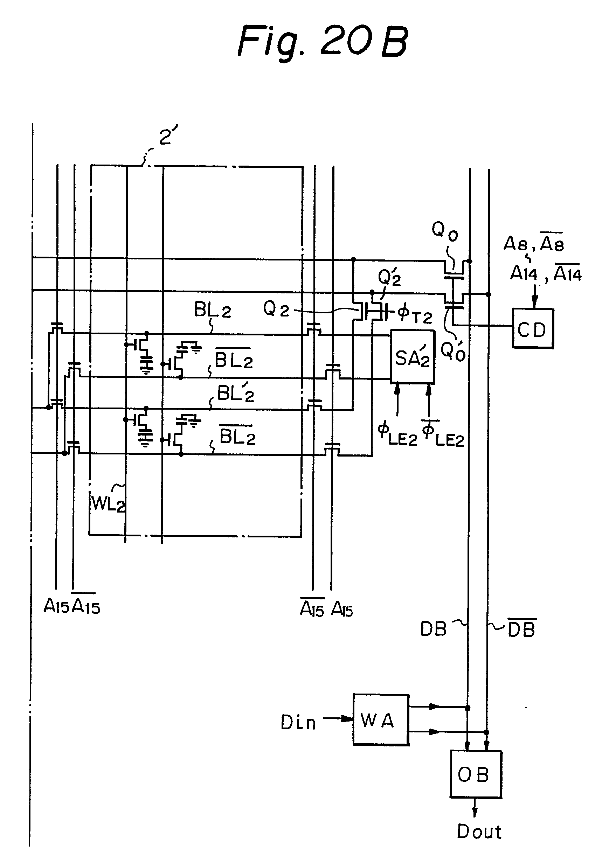

Figure 20 also illustrates a RAM having folded bit lines. For example, in the memory cell array 1', when the bit lines $BL_1$ and $\overline{BL}_1$ are connected to the sense amplifier $SA_1$' by the column address signals $A_{15}$ and $\overline{A}_{15}$ , the bit lines $BL_1$' and $\overline{BL}_1$' are connected to the sense amplifier $SA_2$. Conversely, when the bit lines $BL_1$' and $\overline{BL}_1$' are connected to the sense amplifier $SA_1$ , the bit lines $BL_1$ and $\overline{BL}_1$ are connected to the sense amplifier $SA_2$. Further, only the bit lines connected to the sense amplifier $SA_1$ can be connected to the bus bit lines $BL_0$ and $\overline{BL}_0$. That is, also in Fig. 18, in a read/rewrite operation, one pair of four pairs of partial bit lines are connected to the bus bit lines.

In the above-mentioned embodiments, a RAM of a two-block or four-block configuration is illustrated, however, the present invention can be applied to a device of a multiple-block configuration such as an eight-block configuration, ....

As explained above, according to the present invention, since bus bit lines are added along the bit lines to which a large number of cells are connected, and the bit lines are divided into a plurality of blocks each of which is connected to the bus bit lines via the transfer gates, there is an advantage in that the read/rewrite cycle can be reduced when the C ratio is improved by the division of bit lines. For example, in a one-transistor dynamic RAM having four divided bit lines, the time period for transmitting data from the memory cells to the data buses can be reduced to about 1/3 according to the present invention.  Also,
the present invention can be applied to an open bit
line configuration RAM as well as a folded bit line
configuration RAM.

CLAIMS

1.    A semiconductor memory device comprising:

a memory cell array (1, 2, ..., 1-1, 1-2; 2-1, 2-2; ...) divided into a plurality of blocks;

a plurality of partial bit line means ($BL_1$, $\overline{BL}_1$, $BL_2$, $\overline{BL}_2$, ...), each provided for one of said plurality of blocks;

a plurality of bus bit line means ($BL_0$, $\overline{BL}_0$), each provided commonly for the respective partial bit line means of each of said plurality of blocks;

a plurality of data transfer means ($Q_1$, $Q_1'$, $Q_2$, $Q_2'$, ...), each linked between one of said plurality of bus bit line means and one of said plurality of partial bit line means; and

selecting means, connected to said plurality of data transfer means, for selecting and turning on at least one of said plurality of data transfer means, so as to transmit data of said memory cell array from the respective partial bit line means via the selected data transfer means to the respective bus bit line means.

2.    A device as set forth in claim 1, further comprising a plurality of sense amplifiers ($SA_1$, $SA_2$, ...), each connected to one of said plurality of partial bit line means, for amplifying the potential at said plurality of partial bit line means.

3.    A device as set forth in claim 2, wherein said plurality of partial bit line means comprises a pair of partial bit lines ($BL_1$, $\overline{BL}_1$, $BL_2$, $\overline{BL}_2$, ...) of a folded type connected to one of said plurality of sense amplifiers.

4.    A device as set forth in claim 2, wherein said plurality of partial bit line means comprises a pair of partial bit lines ($BL_1$, $\overline{BL}_1$, $BL_2$, $\overline{BL}_2$, ...) of an open type connected to one of said plurality of sense amplifiers.

5.    A device as set forth in claim 1, further comprising:

common data bus means (DB, $\overline{DB}$); and

selecting means (CD), linked between said plurality of bus bit line means and said common data bus means, for selecting one of said plurality of bus bit line means and connecting it to said common data bus means.

6. A device as set forth in claim 2, where each of said plurality of sense amplifiers incorporates an active restore circuit.

7. A device as set forth in claim 6, further comprising refreshing means, connected to said memory cell array, for transmitting data of each block of said memory cell array to the respective partial bit line means, without turning on said plurality of data transfer means.

8. A device as set forth in claim 6, further comprising refreshing means, connected to said memory cell array and said plurality of data transfer means, for transmitting data of each block of said memory cell array to the respective partial bit line means, with turning on only one of said plurality of data transfer means.

9. A device as set forth in claim 1, further comprising active restore circuits (AR), each connected to one of said plurality of bus bit line means, for pulling up the higher potential at said plurality of partial bit one means.

10. A device as set forth in claim 9, further comprising refreshing means, connected to said memory cell array, for transmitting data of each block of said memory cell array to the respective partial bit line means, without turning on said plurality of data transfer means.

11. A device as set forth in claim 9, further comprising refreshing means, connected to said memory cell array and said plurality of data transfer means, for transmitting data of each block of said memory cell array to the respective partial bit line means, turning on only one of said plurality of data transfer means.

0166642

*Fig. 1A*

*Fig. 1*

| *Fig. 1 A* | *Fig. 1 B* |
|------------|------------|

1

$A_8, \overline{A_8}$
$\sim$
$A_{15} \sim \overline{A_{15}}$

$Q_1$   $Q_1'$

$CD_1$

$BL_1$

$SA_1$

$\overline{BL_1}$

$\phi_{LE}$

$WL_1$

R D

$A_0, \overline{A_0} \sim A_6, \overline{A_6}, A_7$

$\overline{DB_1}$

$DB_1$

$O\ B_1$

$Dout_1$

Fig. IB

Fig. 2A

Fig. 2

| Fig. 2 A | Fig. 2 B |

3/30

0166642

0166642

## Fig. 2B

0166642

Fig. 3

| Fig. 3A | Fig.3 B |

# Fig. 3A

0166642

# Fig. 3B

## Fig. 4

SEL₃

$\phi_{LE}$

$A_7$

$\overline{A_7}$

$\phi_{LE1}$

$\phi_{LE2}$

## Fig. 7

SEL'₃

$\phi_{LE}$

$A_6$

$A_7$

$\overline{A_6}$

$\overline{A_7}$

$\phi_{LE1}$

$\phi_{LE2}$

$\phi_{LE3}$

$\phi_{LE4}$

Fig. 5

Fig.6

| Fig. 6A | Fig. 6B |
|---------|---------|

Fig. 6A

Fig. 6B

Fig. 8

0166642

Fig. 9A

Fig. 9

| Fig. 9 A | Fig. 9 B |
|---|---|

# Fig. 9B

Fig. 10

Fig.11

# Fig. 12

Fig. 13

Fig. 14

*Fig. 15A*

*Fig. 15*

| Fig. 15A | Fig. 15B |

Fig.15B

20/30

016642

Fig. 16

| Fig. 16A | Fig. 16B |

Fig. 16 A

ROW CONTROL AND
REFRESH CIRCUIT ~5

$A_0, \overline{A_0} \sim A_7, \overline{A_7}$

## Fig. 16B

# Fig. 17A

Fig. 17

| Fig. 17A | Fig.17B |

*Fig. 17B*

*Fig.18*

| *Fig.18A* | *Fig.18B* |
|---|---|

*Fig. I8A*

# Fig. 18 B

Fig. 19

| Fig. 19A | Fig.19B |

Fig.19A

# Fig. 19B

0166642

Fig. 20

| Fig. 20A | Fig. 20B |

# Fig. 20A

## Fig. 20 B